# EUROPEAN PATENT APPLICATION

(11) **EP 4 776 815 A1**
(43) Date of publication of application: **15.07.2026**
(21) Application number: 24952580.9
(22) Date of filing: 19.09.2024
(51) Int. Cl.: H10K 59/82, H10K 59/10

(54) **DISPLAY PANEL AND DISPLAY APPARATUS**

(30) Priority: 29.08.2024 CN 202411207394
(71) Applicant: Wuhan Tianma Microelectronics Co., Ltd., Wuhan, Hubei 430205 (CN)
(72) Inventor: YANG, Yuehua, Wuhan, Hubei 430205 (CN)
(74) Representative: Germain Maureau
(86) International application number: PCT/CN2024/119586
(87) International publication number: WO 2026/044842

(57) **Abstract**

Provided in embodiments of the present invention are a display panel and a display apparatus. The display panel comprises a display area and a first non-display area located on one side of the display area in a first direction, wherein the first non-display area comprises a substrate and a first power supply structure; the first power supply structure comprises a first portion and a second portion, the first portion and the second portion are in different layers and are electrically connected to each other, and the second portion comprises a first sub-portion and a second sub-portion that are electrically connected to each other; in a direction perpendicular to a plane where the substrate is located, the first sub-portion overlaps the first portion; and in the first direction, the second sub-portion is located on the side of the first sub-portion away from the display area, the length of the second sub-portion in a second direction is greater than that of the first sub-portion in the second direction, and the second direction intersects the first direction. The present invention can reduce the impedance of the first power supply structure, thereby improving the brightness uniformity of the display area.

## Description

This application claims priority to Chinese Patent Application No. 202411207394.8, entitled "DISPLAY PANEL AND DISPLAY APPARATUS", filed on August 29, 2024, with the China National Intellectual Property Administration, the content of which is incorporated herein by reference in its entirety.

### TECHNICAL FIELD

The present disclosure relates to the field of display technologies, and in particular, to a display panel and a display apparatus.

### BACKGROUND

Compared to a traditional liquid crystal display, an organic light-emitting diode (OLED) display screen is thinner and lighter, have high brightness, low power consumption, fast response, high definition, good flexibility, and high luminous efficiency, which can meet new requirements of consumers on display technologies. However, the current technical solution for narrowing a lower frame may lead to an increase in the impedance of power traces of the lower frame, thereby affecting the brightness uniformity.

### SUMMARY

Embodiments of the present disclosure provide a display panel and a display apparatus to address the technical issues of reducing the impedance of power traces of the lower frame and improving the brightness uniformity.

In a first aspect, an embodiment of the present disclosure provides a display panel, including a display area and a first non-display area located at a side of the display area along a first direction, and the first non-display area includes a substrate and a first power supply structure; the first power supply structure includes a first part and a second part that are arranged in different layers and are electrically connected to each other, and the second part includes a first sub-part and a second sub-part that are electrically connected to each other; in a direction perpendicular to a plane of the substrate, the first sub-part overlaps with the first part; and along the first direction, the second sub-part is located at a side of the first sub-part away from the display area, a length of the second sub-part in a second direction is greater than a length of the first sub-part in the second direction, and the second direction intersects with the first direction.

In another aspect, based on a same inventive concept, an embodiment of the present disclosure further provide a display apparatus, including the display panel according to any embodiment of the present disclosure.

The display panel and the display apparatus according to the embodiments of the present disclosure have the following beneficial effects: in the embodiments of the present disclosure, the first power supply structure includes a first part and a second part which are arranged in different layers and electrically connected to each other. The first sub-part in the second part overlaps with the first part, the second sub-part in the second part is located at a side of the first sub-part away from the display area, and a length of the second sub-part in the second direction is greater than a length of the first sub-part in the second direction. The shape of the second part is designed, such that the length of the second sub-part in the second part in the second direction is configured to be larger, increasing an area of the second part in the first power supply structure, reducing the impedance of the first power supply structure, and improving the brightness uniformity of the display area.

### BRIEF DESCRIPTION OF DRAWINGS

In order to better illustrate the technical solutions in embodiments of the present disclosure or the related art, the drawings used in the description of the embodiments will be briefly illustrated as follows. It should be noted that, the drawings described below are merely some of, rather than all of the embodiments of the present disclosure. Based on these drawings, those skilled in the art can obtain other drawings without any creative efforts.
FIG. 1 is a partial schematic diagram of a display panel in the related art;
FIG. 2 is a partial schematic diagram of a display panel according to an embodiment of the present disclosure;
FIG. 3 is a partial enlarged view of an area Q1 shown in FIG. 2;
FIG. 4 is a schematic structural diagram of two film layers where a first power supply structure is located in an area Q1;
FIG. 5 is another schematic structural diagram of two film layers where a first power supply structure is located according to an embodiment of the present disclosure;
FIG. 6 is a schematic cross-sectional view taken along A-A' shown in FIG. 3;
FIG. 7 is a schematic cross-sectional view taken along B-B' shown in FIG. 3;
FIG. 8 is a partial schematic diagram of another display panel according to an embodiment of the present disclosure;
FIG. 9 is a schematic diagram of another display panel according to an embodiment of the present disclosure;
FIG. 10 is a partial schematic diagram of another display panel according to an embodiment of the present disclosure;
FIG. 11 is a schematic cross-sectional view taken along C-C' shown in FIG. 10;
FIG. 12 is a schematic cross-sectional view taken along D-D' shown in FIG. 10;
FIG. 13 is a schematic diagram of the third part shown in FIG. 10;
FIG. 14 is a partial schematic diagram of another display panel according to an embodiment of the present disclosure; and
FIG. 15 is a schematic diagram of a display apparatus according to an embodiment of the present disclosure.

### DESCRIPTION OF EMBODIMENTS

In order to more clearly illustrate objectives, technical solutions, and advantages of embodiments of the present disclosure, the technical solutions in embodiments of the present disclosure are clearly and completely described in details with reference to the drawings. It should be noted that, the embodiments described are only some rather than all of the embodiments of the present disclosure. Based on the described embodiments of the present disclosure, all other embodiments obtained by those ordinary skilled in the art without creative efforts shall fall within the protection scope of the present disclosure.

Various modifications and changes can be made to the present disclosure without departing from the scope of the disclosure, which are obvious to those skilled in the art. Accordingly, the present disclosure is intended to cover the modifications and variations of the present disclosure that fall within the scope of corresponding claims (claimed technical solutions) and their equivalents. It should be noted that the implementation manners provided by the embodiments of the present disclosure can be combined with each other if there is no contradiction.

The terms used in the embodiments of the present disclosure are merely for the purpose of describing specific embodiments, but not intended to limit the present disclosure. Singular forms of "a/an", "said" and "the" used in the embodiments of the present disclosure and the appended claims are also intended to include plural forms, unless explicitly indicating other meanings.

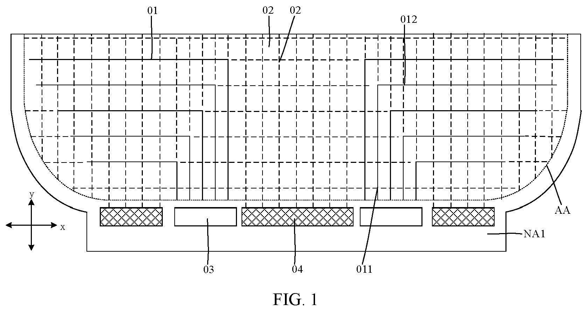

FIG. 1 is a partial schematic diagram of a display panel in the related art. As shown in FIG. 1, the display panel includes a display area AA and a first non-display area NA1, and the first non-display area NA1 is a lower frame area of the display panel. Data connection lines 01 are provided in the display area AA, and the data connection line 01 is introduced into the display area AA from a boundary position between the first non-display area NA1 and the display area AA, and is connected to a data line in the display area AA. The arrangement of the data connection lines 01 in the display area AA can reduce an area occupied by data leads arranged in a fan-out shape in the first non-display area NA1, which is beneficial to narrowing a lower frame. Power signal lines 02 intersecting horizontally and vertically and connected to each other are further provided in the display area AA. The power signal lines 02 are manufactured by using a metal layer for manufacturing the data connection lines 01, and the power signal lines 02 of mesh traces is formed in the display area AA, reducing the voltage drop of the power signal, and improving the uniformity of the reflectivity in the display area AA. A positive power supply structure 03 and a negative power supply structure 04 are provided in the first non-display area NA1. For example, the positive power supply structure 03 is configured to provide a positive power voltage for display, and the negative power supply structure 04 is configured to provide a negative power voltage for display. The power signal line 02 extending along a first direction y in a middle area of the display area AA is connected to the negative power supply structure 04, and the positive power supply structure 03 corresponds to an arrangement area of first line segments 011. The first line segment 011 is a partial line segment on the data connection line 01, and the first line segment 011 extends along the first direction y and is introduced into the display area AA from a boundary position between the first non-display area NA1 and the display area AA.

That is, at a position adjacent to the first non-display area NA1 in the display area AA, an area where the mesh power signal lines 02 are located corresponds to the negative power supply structure 04, and an area where the first line segments 011 are arranged corresponds to the positive power supply structure 03. In the solution of providing the mesh power signal lines 02 and the corresponding negative power supply structure 04, a width of the positive power supply structure 03 in the first non-display area NA1 in the second direction x is affected by the number of the data connection lines 01. The bigger the number of the data connection lines 01 is, the larger the width of the positive power supply structure 03 in the second direction x is. The greater the length of a second line segment 012 extending along the second direction x in the data connection line 01, the larger the coupling capacitance. To prevent the coupling capacitance from being too large, the length of the second line segment 012 is also limited, thereby limiting the number of the data connection lines 01. Further, the data lines in the display area AA corresponding to a corner R (i.e., an arc-shaped corner of the display area) of the display panel are usually connected to data terminals through the data connection lines 01, so that data leads do not need to be arranged near the corner R, thereby narrowing the frame. A magnitude of an arc angle of the corner R also affects the number of the data connection lines 01. The number of the data connection lines 01 affects a width of the positive power supply structure 03 in the second direction x. A smaller width of the positive power supply structure 03 in the second direction x can cause the impedance of the positive power supply structure 03 to increase, which is not conducive to the brightness uniformity of the display area.

In order to address the issues in the related art, and considering the requirements of configuring the data connection lines to reduce the lower frame and reduce the impedance of the first power supply structure (such as the positive power supply structure), an embodiment of the present disclosure provide a display panel, in which shapes of the first power supply structure and the second power supply structure in the first non-display area are designed to increase an area of the first power supply structure, and reduce the impedance of the first power supply structure, thereby improving the brightness uniformity of the display area.

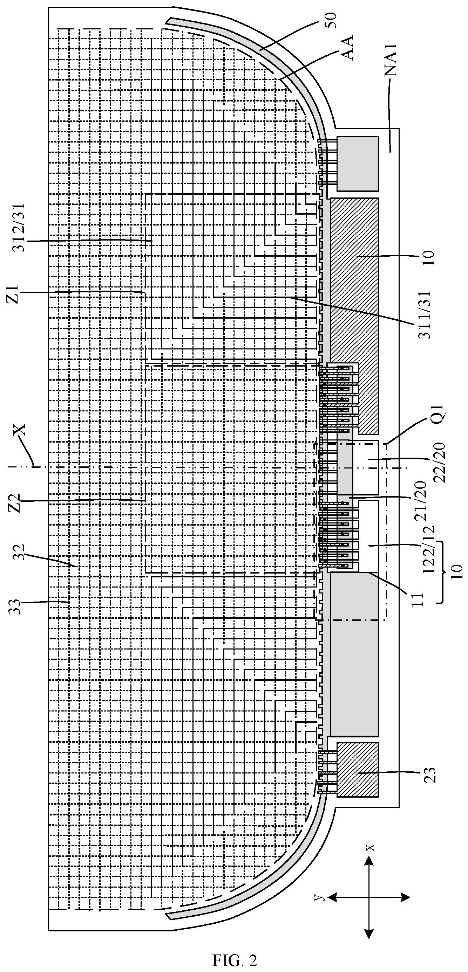

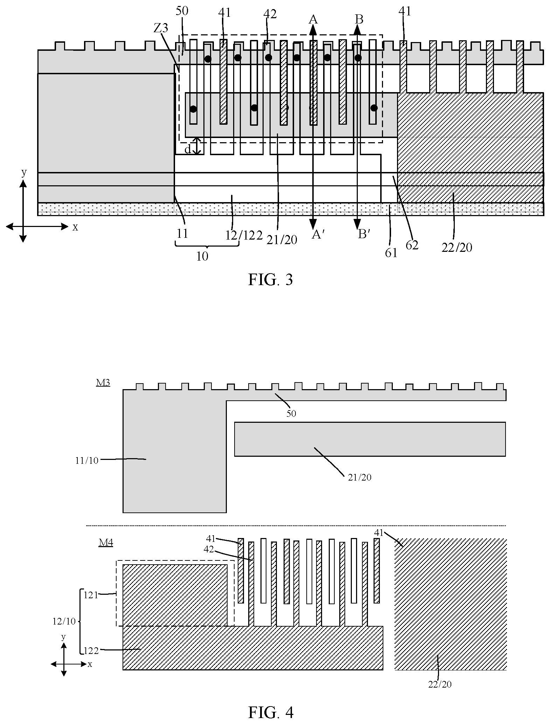

FIG. 2 is a partial schematic diagram of a display panel according to an embodiment of the present disclosure, and FIG. 3 is a partial enlarged view of an area Q1 shown in FIG. 2. As shown in FIG. 2, the display panel includes a display area AA and a first non-display area NA1 located at a side of the display area AA along the first direction y, and the first non-display area NA1 includes a first power supply structure 10 and a second power supply structure 20. A plurality of light-emitting devices (not shown in FIG. 2) are provided in the display area AA, and the light-emitting devices can be organic light-emitting devices or inorganic light-emitting devices. The first power supply structure 10 is configured to provide a positive power voltage to the light-emitting device in the display area AA, and the second power supply structure 20 is configured to provide a negative power voltage. Taking the light-emitting device being an organic light-emitting device as an example, the light-emitting device includes an anode, a light-emitting layer and a cathode which are stacked. Anodes of the light-emitting devices are isolated from each other, and cathodes of the light-emitting devices are connected to each other to form a common electrode. The anode of the light-emitting device receives the positive power voltage through the pixel circuit, and the cathode of the light-emitting device receives the negative power voltage.

FIG. 4 is a schematic structural diagram of two film layers where a first power supply structure is located in an area Q1. Referring to FIG. 2 to FIG. 4, the first power supply structure 10 includes a first part 11 and a second part 12, the first part 11 and the second part 12 are arranged in different layers and electrically connected to each other, and the second part 12 includes a first sub-part 121 and a second sub-part 122 connected to each other. The first part 11 is located in a third metal layer M3 above the substrate, and the second part 12 is located in a fourth metal layer M4 above the substrate. It can be seen from the top view shown in FIG. 3 that the first sub-part 121 overlaps with the first part 11 in a direction perpendicular to a plane of the substrate. Referring to FIG. 2, the second sub-part 122 is located at a side of the first sub-part 121 away from the display area AA. A length of the second sub-part 122 in the second direction x is greater than a length of the first sub-part 121 in the second direction x, and the second direction x intersects with the first direction y. In other words, the second part 12 protrudes outward in the second direction x relative to the first part 11.

In an embodiment of the present disclosure, the first power supply structure 10 includes a first part 11 and a second part 12 which are arranged in different layers and electrically connected to each other. The first sub-part 121 in the second part 12 overlaps with the first part 11, the second sub-part 122 in the second part 12 is located at a side of the first sub-part 121 away from the display area AA, and a length of the second sub-part 122 in the second direction x is greater than a length of the first sub-part 121 in the second direction x. The shape of the second part 12 is designed, such that the length of the second sub-part 122 in the second part 12 in the second direction x is configured to be larger, increasing an area of the second part 12 in the first power supply structure 10, reducing the impedance of the first power supply structure 10, and improving the brightness uniformity of the display area.

As shown in FIG. 2, the display area AA includes a data connection line 31, a second power signal line 32, and a second auxiliary power line 33. The second power signal line 32 extends along the first direction y, the second auxiliary power line 33 extends along the second direction x, and the second power signal line 32 intersects and is electrically connected to the second auxiliary power line 33. One end of the data connection line 31 is electrically connected to a data line (not shown) in the display area AA, and another end of the data connection line 31 is connected to a data terminal of the non-display area. The data terminal is connected to a display driving chip, and provides a data signal to the data line through the data connection line 31. The data connection line 31 includes at least one first line segment 311 extending along the first direction y and at least one second line segment 312 extending along the second direction x. The first line segment 311 and the second power signal line 32 are located in the same layer, and the second line segment 312 and the second auxiliary power line 33 are located in the same layer.

The display area AA includes a first area Z1 and a second area Z2 both adjacent to the first non-display area NA1. A plurality of first line segments 311 are continuously arranged along the second direction x in the first area Z1, and a plurality of second power signal lines 32 are continuously arranged along the second direction x in the second area Z2. The first line segments 311 in the first area Z1 are introduced into the display area AA from a boundary position between the first non-display area NA1 and the display area AA. Along the first direction y, the first power supply structure 10 at least partially overlaps with the first area Z1, and the second power supply structure 20 at least partially overlaps with the second area Z2.

FIG. 2 shows that the first power supply structure 10 corresponds to the arrangement area of the first line segments 311 in the data connection lines 31, and the second power supply structure 20 corresponds to the arrangement area of the second power signal lines 32. As shown in the enlarged view in FIG. 3, the second power supply structure 20 at the middle position is connected to the second power signal line 32 in the display area AA through the first connection line 41.

In the display panel according to the embodiments of the present disclosure, data connection lines 31 are provided in the display area AA. The data connection lines 31 are configured to connect the data lines in the display area AA, thereby reducing an area occupied by the data leads (the data leads are configured to connect the data lines and the data terminals) arranged in the fan-out shape in the first non-display area NA1, and facilitating narrowing the lower frame. The second power signal line 32 and the second auxiliary power line 33 are manufactured by using the manufacturing film layer of the data connection lines 31, so that the second power signal line 32 and the second auxiliary power line 33 intersect and are electrically connected with each other to form a mesh trace, which not only can reduce the voltage drop of the transmitted power signal, but also can improve the uniformity of the in-plane metal line layout, thereby ensuring the relative uniformity of the reflectivity in the display area AA, and improving the display effect. A second power supply structure 20 connected to the second power signal line 32 is provided in the first non-display area NA1 to provide a signal to the second power signal line 32.

As shown in FIG. 2 to FIG. 4, the second power supply structure 20 includes a third part 21 arranged in the same layer as the first part 11, and the first part 11 and the third part 21 are arranged along the second direction x. Along the first direction y, the third part 21 is located on a side of the second sub-part 122 close to the display area AA. The third part 21 at least partially overlaps with the second sub-part 122 in the first direction y. In the second part 12 of the first power supply structure 10, a width of the second sub-part 122 in the second direction x is greater than a width of the first sub-part 121 in the second direction x, and the third part 21 of the second power supply structure 20 is located at a side of the second sub-part 122 close to the display area AA. That is, an area of the second sub-part 122 is enlarged, so that the second sub-part 122 overlaps with the third part 21 of the second power supply structure 20 in the first direction y. By changing the shape of the second part 12 in the first power supply structure 10 to increase the area of the second part 12, the corresponding relationship between the third part 21 in the second power supply structure 20 and the display area AA may not be changed, and the corresponding connection relationship between the second power supply structure 20 and an arrangement area of the second power signal lines 32 is not affected. The second sub-part 122 in the second part 12 overlaps with the third part 21 in the first direction y, which can increase the area of the second part 12 in the first power supply structure 10, thereby reducing the impedance of the first power supply structure 10 and improving the brightness uniformity of the display area.

As shown in FIG. 3 and FIG. 4, the second power supply structure 20 includes a fourth part 22, the fourth part 22 and the third part 21 are arranged in different layers and electrically connected to each other, and a length of the fourth part 22 in the second direction x is less than a length of the third part 21 in the second direction x. The fourth part 22 and the second part 12 are in the same layer, and the fourth part 22 and the second part 12 are arranged along the second direction x. It can be seen from the top view that the fourth part 22 and the third part 21 overlap to form an L-shaped structure, and the first part 11 and the second part 12 overlap to form an L-shaped structure. The second part 12 and the third part 21 overlap in the first direction y, so that the first power supply structure 10 and the second power supply structure 20 are concavo-convex staggered and interlocked with each other, which can increase the area of the second part 12 in the first power supply structure 10 without reducing the length occupied by the second power supply structure 20 in the second direction x, thereby reducing the impedance of the first power supply structure 10, and improving the brightness uniformity of the display area.

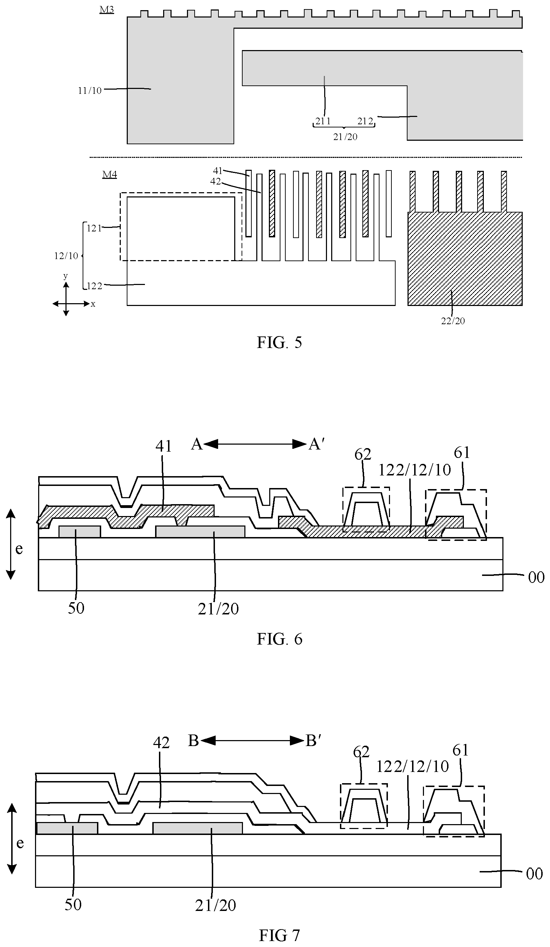

In some embodiments, FIG. 5 is another schematic structural diagram of two film layers where the first power supply structure is located according to an embodiment of the present disclosure. The third part 21 includes a third sub-part 211 and a fourth sub-part 212 connected to each other, and the fourth sub-part 212 is located at a side of the third sub-part 211 away from the display area AA along the first direction y. A length of the fourth sub-part 212 in the second direction x is less than a length of the third sub-part 211 in the second direction x. In a direction perpendicular to the plane of the substrate, the fourth sub-part 212 and the fourth part 22 overlap and are electrically connected to each other. Such an arrangement can increase the area of the third part 21, which is beneficial to reducing the impedance of the second power supply structure 20.

In an embodiment, as shown in FIG. 2, the display panel includes two first power supply structures 10, and the two first power supply structures 10 are respectively located at two sides of the second power supply structure 20 in the second direction x. The two first power supply structures 10 refer to two first power supply structures 10 that are located at different positions and are not in direct contact with each other. In fact, the two first power supply structures 10 are electrically connected to a first power trace 50, so that the two first power supply structures 10 are electrically connected to each other. The display area AA is provided with a central line X extending along the first direction y, and an extension line of the central line X overlaps with the second power supply structure 20. The shape of the display area AA is symmetric with respect to the central line X. The third part 21 includes a first end portion and a second end portion in the second direction x. FIG. 2 does not indicate the first end portion and the second end portion. The first end portion and the second end portion can be understood as two ends of the third part 21 in the second direction x. Along the first direction y, the first end portion is located at a side of the second sub-part 122 of one first power supply structure 10 close to the display area AA, and the second end portion is located at a side of the second sub-part 122 of the other first power supply structure 10 close to the display area AA. That is, the length of the fourth part 22 in the second power supply structure 20 in the second direction x is reduced, so that the third part 21 and the fourth part 22 form a T-shaped structure, and two second sub-parts 122 in the first power supply structures 10 on two sides of the second power supply structure 20 can respectively overlap with the end portions of the third part 21 in the first direction y, thereby reducing the impedance of the first power supply structure 10 to a large extent, and improving the brightness uniformity of the display area.

Further, as shown in FIG. 2, two edge second power supply structures 23 are further provided in the first non-display area NA1. The edge second power supply structures 23 are located at end portions of the first non-display area NA1 in the second direction x, and the edge second power supply structures 23 transmit the same signal as the second power supply structure 20 at the central position.

In some embodiments, as shown in FIG. 2, the length of the fourth part 22 is less than the length of the second part 122 along the second direction x. Since the fourth part 22 in the second power supply structure 20 and the second sub-part 122 in the first power supply structure 10 are located in the same film layer, in a limited space of the first non-display area NA1, reducing the length of the fourth part 22 in the second direction x can increase the length of the second sub-part 122, thereby increasing the area of the second part 12 in the first power supply structure 10, and reducing the impedance of the first power supply structure 10.

With reference to FIG. 2 and FIG. 3, the display area AA includes a second power signal line 32 extending along the first direction y, and the first non-display area NA1 includes a plurality of first connection lines 41 extending along the first direction y. One end of the first connection line 41 is connected to the second power supply structure 20, and another end of the first connection line 41 is connected to the second power signal line 32. The first connection line 41 and the fourth part 22 are located in the same layer. It can be seen from FIG. 3 that one end of a subset of the first connection lines 41 is connected to the third part 21, and one end of a subset of the first connection lines 41 is connected to the fourth part 22. A black solid circle in FIG. 3 shows the connection position of the first connection line 41 and the third part 21 through a via hole. According to an embodiment of the present disclosure, in the second power supply structure 20, the length of the fourth part 22 in the second direction x is smaller than the length of the third part 21 in the second direction x. The area of the second part 12 in the first power supply structure 10 can be increased in the same film layer as the fourth part 22 by reducing the length of the fourth part 22 in the second direction x, and the impedance of the first power supply structure 10 can be reduced by increasing the area of the second part 12. In addition, it is ensured that the length of the third part 21 in the second power supply structure 20 in the second direction x is still large enough, and the first connection line 41 extending along the first direction y can still be used to connect the second power supply structure 20 and the second power signal line 32 located in the display area AA, so as to ensure the reliable electrical property of the second power supply structure 20.

FIG. 6 is a schematic cross-sectional view taken along A-A' shown in FIG. 3. The same filling pattern in FIG. 6 represents the same film layer. FIG. 6 shows a substrate 00. It can be seen from FIG. 6 that the first power trace 50 and the third part 21 in the second power supply structure 20 are located in the same film layer, and the first connection line 41 and the second part 12 in the first power supply structure 10 are located in the same film layer. FIG. 6 shows that the first connection line 41 is connected to the third part 21 through a via hole penetrating the insulating layer.

In some embodiments, as shown in FIG. 2, the first non-display area NA1 includes a first power trace 50. The first power trace 50 is located at a side of the first power supply structure 10 and the second power supply structure 20 close to the display area AA, and the first power supply structure 10 is electrically connected to the first power trace 50. The first power trace 50 is routed around a lower edge of the display area AA. In an example, the first power trace 50 and the first part 11 in the first power supply structure 10 are located in the same layer and are in contact connection to each other.

The display panel includes a plurality of second connection lines 42 extending along the first direction y as shown in FIG. 3. It can be seen from the top view of FIG. 3 that at least one second connection line 42 at least partially overlaps with the third part 21 along the direction perpendicular to the plane of the substrate. One end of the second connection line 42 is connected to the second part 12, and another end of the second connection line 42 is connected to the first power trace 50. In an example, one end of the second connection line 42 is connected to the second sub-part 122 in the second part 12.

FIG. 7 is a schematic cross-sectional view taken along B-B' shown in FIG. 3. The same filling pattern in FIG. 7 represents the same film layer. FIG. 7 shows a substrate 00. It can be seen from FIG. 7 that the second connection line 42 is connected to the first power trace 50 through a via hole penetrating the insulating layer, and the second connection line 42 and the second part 12 in the first power supply structure 10 are located in the same film layer. The third part 21 in the second power supply structure 20 and the first power trace 50 are located in the same layer. That is, the first power trace 50, the first part 11 in the first power supply structure 10, and the third part 21 in the second power supply structure 20 are located in the same layer, the second part 12 in the first power supply structure 10, and the fourth part 22 in the second power supply structure 20 are located in the same layer, and the first power supply structure 10 and the second power supply structure 20 respectively include parts located in two metal layers, so that impedances of the two power supply structures are relatively low, which is beneficial to reducing a voltage drop of a power signal and improving display uniformity.

In an embodiment of the present disclosure, the second connection line 42 extending along the first direction y is provided, and the second connection line 42 is connected between the first power trace 50 and the second sub-part 122 of the second part 12. The second connection line 42 is used to connect the first power trace 50 and the first power supply structure 10 to form a grid structure in the first non-display area NA1, which can further reduce the voltage drop of the power voltage transmitted by the first power supply structure 10, thereby improving the display uniformity. Further, an overlapping area between the second connection line 42 and the third part 21 is small, so that an overlapping area between a structure for transmitting the positive power voltage and a structure for transmitting the negative power voltage is not large, and the display panel has better reliability.

As shown in FIG. 4, the first connection line 41, the second connection line 42, the second part 12 of the first power supply structure 10, and the fourth part 22 of the second power supply structure 20 are located in the same film layer.

In some embodiments, as shown in FIG. 6 and FIG. 7, the first non-display area NA1 includes a first retaining wall 61 and a second retaining wall 62. Along a direction e perpendicular to the plane of the substrate, the second sub-part 122 at least partially overlaps with the first retaining wall 61. With reference to FIG. 3, the first retaining wall 61 is located at a side of the second retaining wall 62 away from the display area. The first retaining wall 61 and the second retaining wall 62 serve as encapsulation boundaries of an encapsulation layer. The encapsulation layer is used to encapsulate and protect the light-emitting device, and the encapsulation layer includes at least one inorganic encapsulation layer and at least one organic encapsulation layer. The second sub-part 122 at least partially overlaps with the first retaining wall 61, that is, the second sub-part 122 extends in the first direction y to an area where the first retaining wall 61 is located, so that the second sub-part 122 has a larger width in the first direction y, which is beneficial to reducing the impedance of the first power supply structure 10 and improving the display uniformity.

In some embodiments, with reference to FIG. 3 and FIG. 6, along the direction e perpendicular to the plane of the substrate, the first retaining wall 61 overlaps with an edge of the second sub-part 122 on a side away from the display area AA in the first direction y. That is, the edge of the second sub-part 122 on a side away from the display area AA in the first direction y is covered by the first retaining wall 61, thereby preventing the edge of the second sub-part 122 from being exposed and corroded, and ensuring the performance reliability of the first power supply structure 10.

As shown in FIG. 3, along the first direction y, a minimum distance between the second sub-part 122 and the third part 21 is d, where d≥3µm. In an embodiment of the present disclosure, the second sub-part 122 and the third part 21 are arranged in different layers, so that a distance between the second sub-part 122 and the third part 21 in the first direction y is small. With reference to FIG. 6, when the distance between the second sub-part 122 and the third part 21 is small, an edge of the second sub-part 122 and an edge of the third part 21 can both be covered using an organic layer, so as to ensure that the edge of the third part 21 is not etched laterally in the subsequent etching process. Configuring d≥3µm can ensured that a coupling capacitance between the second sub-part 122 and the third part 21 is small, so that a coupling capacitance between the first power supply structure 10 and the second power supply structure 20 is small, and the reliability of the power voltage transmitted by the first power supply structure 10 and the second power supply structure 20 is higher.

In some embodiments, with reference to FIG. 2 and FIG. 3, the first non-display area NA1 includes a first sub-area Z3. Along the first direction y, the first sub-area Z3 is located between the second sub-part 122 of the second part 12 (the position thereof is understood with reference to FIG. 4) and the display area AA. Along the second direction x, the first sub-area Z3 is located between the first sub-part 121 (the position thereof is understood with reference to FIG. 4) and the fourth part 22. In the first sub-area Z3, n first connection lines 41 form a connection line group (not shown in FIG. 3), and the second connection lines 42 and connection line groups are alternately arranged along the second direction x. FIG. 3 takes n=1 as an example, that is, the first connection lines 41 and the second connection lines 42 are alternately arranged in the second direction x in the first sub-area Z3.

With reference to FIG. 2, the first connection line 41 connects the second power supply structure 20 and the second power signal line 32 located in the display area AA. The pixel circuits arranged along the first direction y in the display area AA form a pixel circuit column. Two adjacent second power signal lines 32 may respectively overlap with two adjacent pixel circuit columns, or one pixel circuit column may be spaced between two adjacent second power signal lines 32. That is, one second power signal line 32 may be correspondingly arranged at a position where one pixel circuit column is arranged, or one second power signal line 32 may be correspondingly arranged at a position where two pixel circuit columns are arranged.

For example, in a solution in which one second power signal line 32 is correspondingly arranged at the position where one pixel circuit column is arranged, when the first connection line 41 is correspondingly connected to the second power signal line 32 in the display area AA, there is a space between adjacent first connection lines 41. As shown in FIG. 3, the second connection line 42 and the first connection line 41 are arranged in the same layer, and the second connection line 42 is arranged between adjacent first connection lines 41, which can not only make full use of the film layer where the first connection line 41 is located, but also use the second connection line 42 to connect the first power trace 50 and the first power supply structure 10 in the first non-display area NA1 to form a grid structure, thereby further reducing the voltage drop of the power voltage transmitted by the first power supply structure 10.

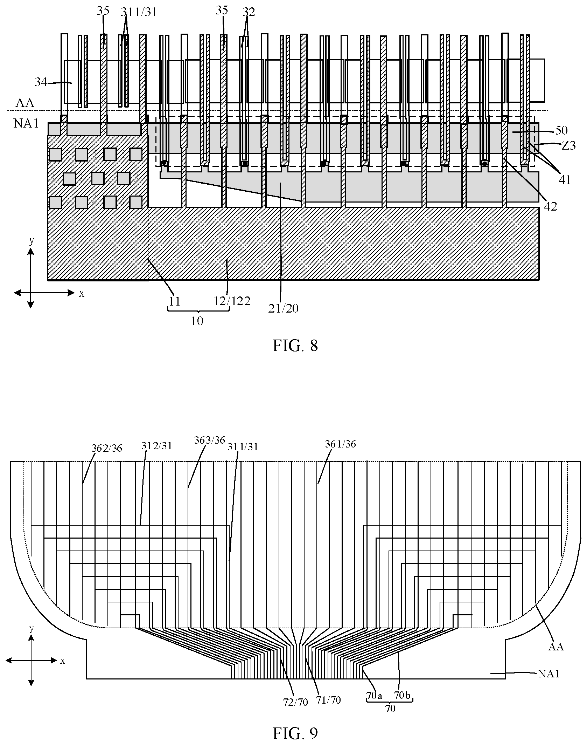

In other embodiments, FIG. 8 is a partial schematic diagram of another display panel according to an embodiment of the present disclosure. FIG. 8 schematically shows some pixel circuits 34 arranged in the display area AA. In the display area AA, a plurality of pixel circuits 34 are arranged in a pixel circuit row along the second direction x, and a plurality of pixel circuits 34 are arranged in a pixel circuit column along the first direction y. FIG. 8 shows one pixel circuit row. As shown in FIG. 8, along the first direction y, the first sub-area Z3 is located between the second sub-part 122 of the second part 12 and the display area AA. In the first sub-area Z3, two first connection lines 41 form a connection line group (that is, n = 2 in the connection line group), and the second connection lines 42 and the connection line groups are alternately arranged in the second direction x. That is, two adjacent second connection lines 42 are spaced apart by two first connection lines 41. In the display area AA, a first line segment 311 in the data connection line 31, a first power signal line 35, and a second power signal line 32 are illustrated. The first power signal line 35 is connected to the first power trace 50, and the second power signal line 32 is connected to the second power supply structure 20 through the first connection line 41.

In an embodiment of FIG. 8, one first power signal line 35 is correspondingly arranged at a position where two pixel circuit columns are arranged. Two second power signal lines 32 are arranged between two adjacent first power signal lines 35 in a portion of the display area AA overlapping with the third part 21 in the first direction y, and two first line segments 311 are arranged between two adjacent first power signal lines 35 in a portion of the display area AA overlapping with the first part 11 in the first direction y. The second power signal lines 32 are arranged according to the arrangement manner of the first line segments 311 in the data connection line 31, improving the uniformity of metal wiring in the display area AA and making the reflectivity in the display area uniform.

In some embodiments, FIG. 9 is a schematic diagram of another display panel according to an embodiment of the present disclosure. As shown in FIG. 9, the display panel includes data lines 36 including a first data line 361 and a second data line 362, and data leads 70 are provided in the first non-display area NA1. The data lead 70 include a first lead segment 70a and a second lead segment 70b. Along the first direction y, the first lead segment 70a is located at a side of the second lead segment 70b away from the display area AA. The first lead segment 70a extends along the first direction y, and an extending direction of the second lead segment 70b intersects with the first direction y and intersects with the second direction x. A plurality of first lead segments 70a are arranged along the second direction x, and a plurality of second lead segments 70b are arranged in a radial pattern, so that the data leads 70 are arranged in a fan shape in the first non-display area NA1. The data leads 70 are also referred to as fan-out lines. It can be seen from FIG. 9 that the data leads 70 include a first data lead 71 and a second data lead 72, and the first data line 361 is electrically connected to the first data lead 71. The second data line 362 is electrically connected to the second data lead 72 through the data connection line 31 located in the display area AA.

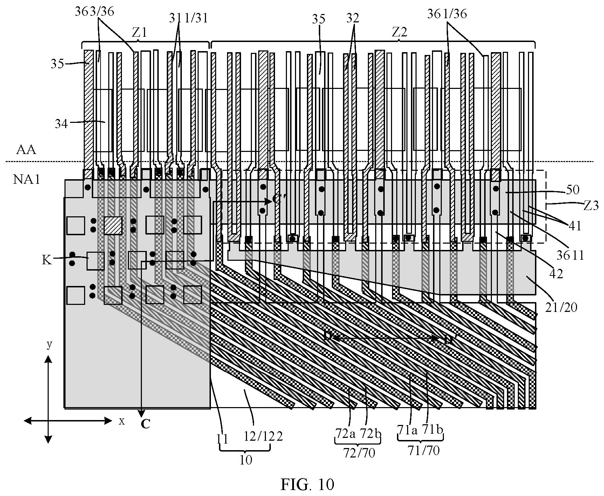

In some embodiments, FIG. 10 is a partial schematic diagram of another display panel according to an embodiment of the present disclosure. FIG. 10 shows the first data lines 361 in the display area AA and the first data leads 71 in the first non-display area NA1. As shown in FIG. 10, the first data line 361 is electrically connected to the first data lead 71, and the first data line 71 extends from the first non-display area NA1 to the display area AA. The first data line 361 includes a first line sub-segment 3611 located in the first non-display area NA1. The first line sub-segment 3611 and the second connection line 42 are located in the same film layer. The first line sub-segment 3611 is connected to the first data lead 71, so that the first data line 361 is electrically connected to the first data lead 71. In embodiments, a line segment of the first data line 361 located in the display area AA and the first line sub-segment 3611 located in the first non-display area NA1 are located in the same layer.

With reference to the second area Z2 in the display area AA shown in FIG. 10, the second area Z2 at least partially overlaps with the second power supply structure 20 along the first direction y. The second power signal line 32 is arranged in the second area Z2, and a plurality of second power signal lines 32 are continuously arranged along the second direction x in the second area Z2. The second power signal line 32 is connected to the second power supply structure 20 through the first connection line 41. First power signal lines 35 are further arranged in the second area Z2, and the first power signal line 35 is connected to the first power supply structure 10 through the second connection line 42. It can be seen from the top view of FIG. 10 that along the direction perpendicular to the plane of the substrate, the first line sub-segment 3611, the first connection line 41, and the second connection line 42 each overlap with the first power trace 50. In the first sub-area Z3, along the second direction x, the first line sub-segment 3611 is adjacent to the second connection line 42 and/or the first connection line 41. The first line sub-segment 3611, the first connection line 41 and the second connection line 42 arranged in the same layer are arranged in the first sub-area Z3, and the metal layer where the first connection line 41 and the second connection line 42 are located is properly wired, which not only can save wiring space, but also can meet corresponding connection requirements of the first line sub-segment 3611, the first connection line 41 and the second connection line 42 and each signal line in the display area AA.

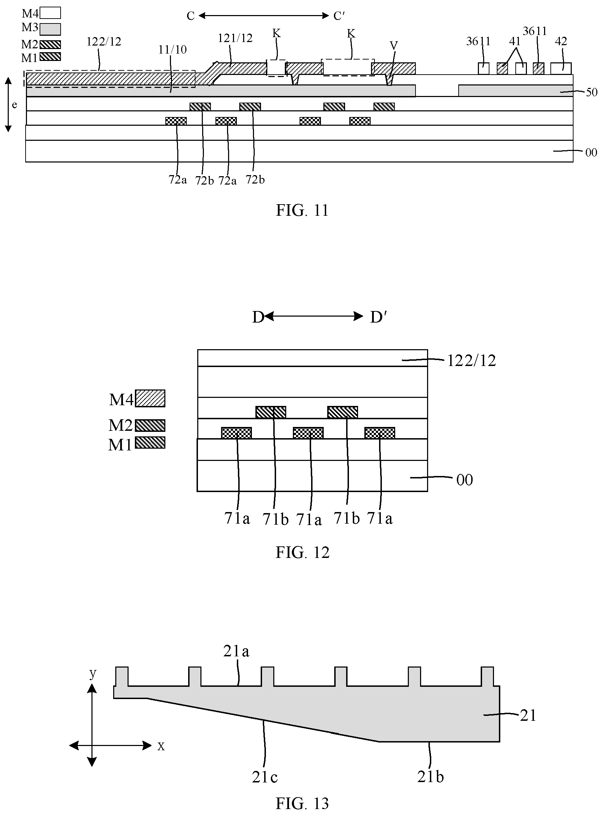

FIG. 11 is a schematic cross-sectional view taken along C-C' shown in FIG. 10. It can be seen from FIG. 11 that along the direction e perpendicular to the plane of the substrate 00, the first line sub-segment 3611, the first connection line 41, and the second connection line 42 each overlap with the first power trace 50. The display panel includes a first metal layer M1, a second metal layer M2, a third metal layer M3, and a fourth metal layer M4 above the substrate 00. The second metal layer M2 is located at a side of the first metal layer M1 away from the substrate 00, the third metal layer M3 is located at a side of the second metal layer M2 away from the substrate 00, and the fourth metal layer M4 is located at a side of the third metal layer M3 away from the substrate 00. The first line sub-segment 3611, the first connection line 41, the second connection line 42, and the second part 12 of the first power supply structure 10 are located in the fourth metal layer M4, and the first power trace 50 and the first part 11 of the first power supply structure 10 are located in the third metal layer M3.

FIG. 12 is a schematic cross-sectional view taken along D-D' shown in FIG. 10. With reference to FIG. 10, FIG. 11 and FIG. 12, the first data line 361 is connected to the first data lead 71, and the first data line 361 extends from the first non-display area NA1 to the display area AA. The first data line 361 is at least partially located in the second area Z2. The first data line 361 includes a first line sub-segment 3611 located in the first non-display area NA1. Along a direction e perpendicular to the plane of the substrate 00, the first line sub-segment 3611 overlaps with the third part 21. The first data lead 71 includes a first data sub-lead 71a located in the first metal layer M1 and a second data sub-lead 71b located in the second metal layer M2. In embodiments, the first metal layer M1 and the second metal layer M2 are made of the same material. The first data sub-leads 71a and the second data sub-leads 71b are electrically connected to respective first line sub-segments 3611 alternately. Such an arrangement can reduce a spacing between two adjacent first data leads 71, thereby reducing the area occupied by the data leads arranged in a fan-out shape, and further facilitating the narrowing of the lower frame of the display panel.

In an embodiment of the present disclosure, the third part 21 of the second power supply structure 20 and the first power trace 50 are located in the same layer, that is, the third part 21 and the first power trace 50 are located in the third metal layer M3. The data line 36 is located in the fourth metal layer M4. In embodiments, the second power signal line 32 and the first line segment 311 in the data connection line 31 are located in the fourth metal layer M4. The data line 36, the first line segment 311 in the data connection line 31 and the second power signal line 32 extending in the same direction are manufactured in the same layer, which can reduce the number of metal layers of the display panel, thereby simplifying the manufacturing process and reducing the manufacturing cost.

In some embodiments, FIG. 13 is a schematic diagram of the third part shown in FIG. 10. With reference to FIG. 10 and FIG. 13, the third part 21 includes a first side 21a, a second side 21b and a third side 21c. The first side 21a is located at a side of the second side 21b close to the display area AA along the first direction y, and the third side 21c is connected to the second side 21b and located between the first side 21a and the second sub-part 122 along the first direction y. The first side 21a and the second side 21b extend along the second direction x, and an angle formed by the first side 21a and the third side 21c is an acute angle. Such an arrangement can increase the distance between the third part 21 and the first part 11 arranged in the same layer, ensuring the reliable electrical performance of the first power supply structure 10 and the second power supply structure 20.

As shown in FIG. 9, the data connection line 31 includes a first line segment 311 extending in the first direction y and a second line segment 312 extending in the second direction x. The data connection line 31 is electrically connected to the second data line 362. FIG. 10 further shows a first area Z1 in the display area AA. The first area Z1 includes the first line segment 311 of the data connection line 31, and a plurality of first line segments 311 are continuously arranged in the first area Z1. It can be seen from FIG. 10 that along the first direction y, the first power supply structure 10 at least partially overlaps with the first area Z1, and the second power supply structure 20 at least partially overlaps with the second area Z2.

The data lines 36 further includes a third data line 363 electrically connected to the second data lead 72. With reference to FIG. 10, an extension line of the third data line 363 overlaps with the first part 11. The third data line 363 is at least partially located in the first area Z1. In a direction perpendicular to the plane of the substrate, at least part of the second data lead 72 overlaps with the first power supply structure 10. Further, one end of the data connection line 31 is connected to the second data line 362, and another end of the data connection line 31 is connected to the second data lead 72. That is, a subset of the second data leads 72 are electrically connected to the third data lines 363, and a subset of the second data leads 72 are connected to the second data lines 362 through the data connection lines 31. The first data line 361 and the third data line 363 are directly connected to respective data leads 70, except that the position of the first data line 361 and the position of the third data line 363 in the display area AA are different.

With reference to FIG. 10 and FIG. 11, the second data lead 72 includes a third data sub-lead 72a located in the first metal layer M1 and a fourth data sub-lead 72b located in the second metal layer M2. The third data sub-lead 72a and the fourth data sub-lead 72b each at least partially overlap with the first part 11 in the first power supply structure 10. The third data sub-leads 72a and the fourth data sub-leads 72b are alternately arranged. Such an arrangement can reduce a spacing between two adjacent second data leads 72, thereby reducing the area occupied by the data leads arranged in a fan-out shape, and further facilitating the narrowing of the lower frame of the display panel.

In some embodiments, as shown in FIG. 11, the first power supply structure 10 includes a first part 11 and a second part 12 arranged in different layers. At least part of the first part 11 and at least part of the second part 12 are electrically connected to each other through a plurality of via holes V, and/or at least part of the first part 11 and at least part of the second part 12 are in planar contact connection. With reference to FIG. 10, in a partial area of the first power supply structure 10 close to the display area AA along the first direction y, the first part 11 and the second part 12 overlap and are connected through a via hole V (the position of the via hole is illustrated by a black solid dot in FIG. 10). In a partial area of the first power supply structure 10 away from the display area AA along the first direction y, the first part 11 and the second part 12 are in planar contact connection. The planar contact connection can increase the contact area between the first part 11 and the second part 12, which is beneficial to reducing the overall impedance of the first power supply structure 10. At the position where the first part 11 and the second part 12 are connected through the via hole V, a hollow K is further provided on the second part 12. The hollow K can help discharge gas in the manufacture process and prevent film delamination.

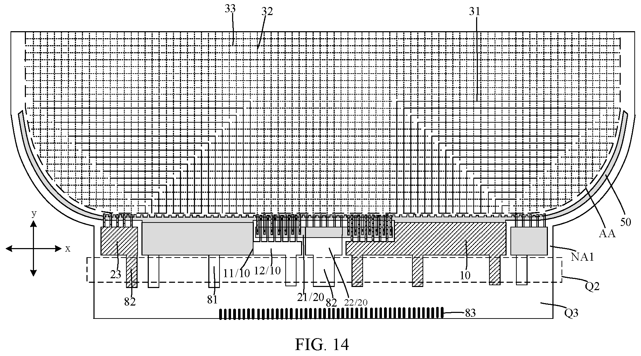

In some embodiments, FIG. 14 is a partial schematic diagram of another display panel according to an embodiment of the present disclosure. As shown in FIG. 14, the first non-display area NA1 further includes a bending area Q2 and a pad area Q3. The inorganic layer on the substrate is removed in the bending area Q2 to enable the bending area Q2 to be bent, and a plurality of pads 83 are provided in the pad area Q3. Along the first direction y, the pad area Q3 is located at a side of the bending area Q2 away from the display area AA. The first non-display area NA1 includes two first power supply structures 10, one second power supply structure 20 located at the central position, and two edge second power supply structures 23 located at the edge positions. The two first power supply structures 10 are respectively electrically connected to first power traces 50. Since the two first power supply structures 10 is spaced apart by the second power supply structure 20, the two first power supply structures 10 are not in contact connection. The second power supply structure 20 and the two edge second power supply structures 23 transmit the same signal, and the edge second power supply structure 23 is electrically connected to the second power signal line 32 in a portion of the display area AA overlapping with the edge second power supply structure 23 in the first direction y. The first non-display area NA1 includes a first cross-over line 81 and a second cross-over line 82. The first cross-over line 81 is connected to the first power supply structure 10 and extends to the pad area Q3 through the bending area Q2. The second power supply structure 20 and the edge second power supply structures 23 are respectively connected to the second cross-over line 82, and the second cross-over line 82 extends to the pad area Q3 through the bending area Q2. One first power supply structure 10 is connected to at least three first cross-over lines 81. The second power supply structure 23/the edge second power supply structures 23 is each connected to one second cross-over line 82. In embodiments, the first cross-over line 81 and the second cross-over line 82 are in the same film layer as the second part 12 in the first power supply structure 10.

In the embodiments of the present disclosure, the second part 12 in the first power supply structure 10 includes a first sub-part 121 and a second sub-part 122. The second sub-part 122 is located at a side of the first sub-part 121 away from the display area AA along the first direction y, and a length of the second sub-part 122 in the second direction x is greater than a length of the first sub-part 121 in the second direction x, thereby increasing the area of the second part 12, which is beneficial to reducing the impedance of the first power supply structure 10. In addition, the second sub-part 122 has a larger length in the second direction x, so that three or more first cross-over lines 81 can be provided on the second sub-part 122, thereby further reducing the impedance, reducing the voltage drop of the power voltage transmitted by the first power supply structure 10, and improving the display uniformity.

In some embodiments, the first cross-over line 81 and the second cross-over line 82 both have a larger width in the second direction x, and a vent hole can be provided on the first cross-over line 81 and/or the second cross-over line 82 to discharge the gas generated in the manufacture process through the vent hole, thereby preventing the film delamination of the first cross-over line 81 and/or the second cross-over line 82 having large areas.

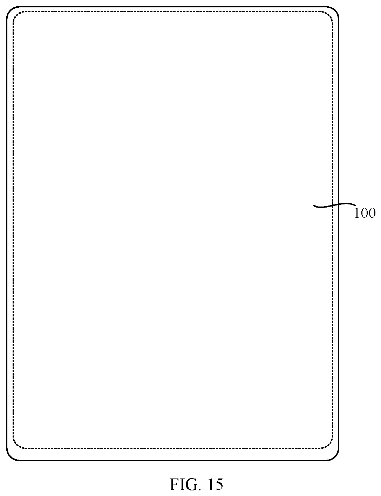

Based on the same inventive concept, an embodiment of the present disclosure further provides a display apparatus. FIG. 15 is a schematic diagram of a display apparatus according to an embodiment of the present disclosure. As shown in FIG. 15, the display apparatus includes the display panel 100 according to any embodiment of the present disclosure. The structure of the display panel 100 has been described in the above embodiments, and will not be repeated herein. The display apparatus according to the embodiments of the present disclosure may be an electronic device having a display function such as a mobile phone, a tablet computer, a laptop computer, or a television.

The above description merely illustrates some preferred embodiments of the present disclosure and is not intended to limit the present disclosure, and any modification, equivalent substitution, improvement and the like made within a spirit and a principle of the present disclosure shall fall with the scope of the present disclosure.

As above, it should be noted that, the above-described embodiments are merely for illustrating the present disclosure but not intended to provide any limitation. Although the present disclosure has been described in detail with reference to the above-described embodiments, it should be understood by those skilled in the art that, it is still possible to modify the technical solutions described in the above embodiments or to equivalently replace some or all of the technical features therein, but these modifications or replacements do not cause the essence of corresponding technical solutions to depart from the scope of the present disclosure.

## Claims

1. A display panel, comprising a display area and a first non-display area that is located at a side of the display area along a first direction,
the first non-display area comprises a substrate and a first power supply structure;
wherein the first power supply structure comprises a first part and a second part that are arranged in different layers and are electrically connected to each other, and the second part comprises a first sub-part and a second sub-part that are electrically connected to each other;
wherein in a direction perpendicular to a plane of the substrate, the first sub-part overlaps with the first part; and
wherein along the first direction, the second sub-part is located at a side of the first sub-part away from the display area, a length of the second sub-part in a second direction is greater than a length of the first sub-part in the second direction, and the second direction intersects with the first direction.

2. The display panel according to claim 1, wherein
the first non-display area further comprises a second power supply structure comprising a third part, the third part is arranged in a same layer as the first part, and the first part and the third part are arranged along the second direction; and
along the first direction, the third part is located at a side of the second part close to the display area, and the third part at least partially overlaps with the second part.

3. The display panel according to claim 2, wherein
the second power supply structure further comprises a fourth part, and the fourth part and the third part are arranged in different layers and are electrically connected to each other; and a length of the fourth part in the second direction is less than a length of the third part in the second direction; and
the fourth part is arranged in a same layer as the second part, and the fourth part and the second part are arranged along the second direction.

4. The display panel according to claim 3, wherein
the third part comprises a third sub-part and a fourth sub-part that are electrically connected to each other, and along the first direction, the fourth sub-part is located at a side of the third sub-part away from the display area;
a length of the fourth sub-part in the second direction is less than a length of the third sub-part in the second direction; and
along the direction perpendicular to the plane of the substrate, the fourth sub-part overlaps with and is electrically connected to the fourth part.

5. The display panel according to claim 3, wherein
in the second direction, the length of the fourth part is less than the length of the second sub-part.

6. The display panel according to claim 3, wherein
the display area comprises a second power signal line, and the first non-display area comprises a plurality of first connection lines extending along the first direction; and one end of the first connection line is connected to the second power supply structure, and another end of the first connection line is connected to the second power signal line; and
the first connection line is arranged in a same layer as the fourth part, one end of a subset of the first connection lines is connected to the third part, and one end of a subset of the first connection lines is connected to the fourth part.

7. The display panel according to claim 3, wherein
the first non-display area comprises a first power trace; the first power trace is located at a side of the first power supply structure and the second power supply structure close to the display area, and the first power supply structure is electrically connected to the first power trace;
the display panel comprises a plurality of second connection lines extending along the first direction;
along the direction perpendicular to the plane of the substrate, at least one of the plurality of second connection lines at least partially overlaps with the third part; and
one end of the second connection line is connected to the second part, and another end of the second connection line is connected to the first power trace.

8. The display panel according to claim 7, wherein
the display area comprises a second power signal line, and the first non-display area comprises a plurality of first connection lines extending along the first direction; one end of the first connection line is connected to the third part, and another end of the first connection line is connected to the second power signal line; and the first connection line and the second connection line are located in a same film layer;
the first non-display area comprises a first sub-area, the first sub-area is located between the second sub-part and the display area along the first direction, and the first sub-area is located between the first part and the fourth part along the second direction; and
in the first sub-area, n first connection lines form a connection line group, the second connection lines and connection line groups are alternately arranged along the second direction, where n=1 or 2.

9. The display panel according to claim 8, further comprising:
a data line and a data lead, wherein the data line comprise a first data line, the data lead comprise a first data lead, the first data line is electrically connected to the first data lead, and the first data line extend from the first non-display area to the display area;
wherein the first data line comprise a first line sub-segment located in the first non-display area; the first line sub-segment and the second connection lines are located in a same film layer; along the direction perpendicular to the plane of the substrate, the first line sub-segment overlaps with the first power trace; and
wherein in the first sub-area, along the second direction, the first line sub-segment is adjacent to the second connection line and/or the first connection line.

10. The display panel according to claim 7, wherein
the third part is arranged in a same layer as the first power trace.

11. The display panel according to claim 2, wherein
the first non-display area comprises a plurality of data leads, the data lead comprises a first lead segment and a second lead segment, and the first lead segment is located at a side of the second lead segment away from the display area along the first direction; and the first lead segment extends along the first direction, and an extending direction of the second lead segment intersects with the first direction and intersects with the second direction;
the display panel comprises a data line comprising a first data line, and an extension line of the first data line overlaps with the third part; the data lead comprises a first data lead, the first data line is connected to a the first data lead, and the first data line extend from the first non-display area to the display area; the first data line comprises a first line sub-segment located in the first non-display area; and the first line sub-segment overlaps with the third part in the direction perpendicular to the plane of the substrate;
the display panel comprises a first metal layer and a second metal layer that are located at a side of the substrate, the second metal layer is located at a side of the first metal layer away from the substrate; and the first data lead comprises a first data sub-leads located in the first metal layer and a second data sub-lead located in the second metal layer; and
a plurality of first data sub-leads and a plurality of second data sub-leads are electrically connected to respective first line sub-segments alternately.

12. The display panel according to claim 11, further comprising a third metal layer and a fourth metal layer that are located at a side of the substrate,
wherein the third metal layer is located at a side of the second metal layer away from the substrate, and the fourth metal layer is located at a side of the third metal layer away from the substrate; and
wherein the data line is located in the fourth metal layer, and the third part is located in the third metal layer.

13. The display panel according to claim 2, wherein
the third part comprises a first side, a second side and a third side, the first side is located at a side of the second side close to the display area along the first direction, and the third side is connected to the second side and located between the second sub-part and the first side along the first direction; and
the first side and the second side extend along the second direction, and an angle formed by the first side and the third side is an acute angle.

14. The display panel according to claim 2, wherein
in the first direction, a minimum distance between the second sub-part and the third part is d, where d≥3µm.

15. The display panel according to claim 2, wherein:
the display panel comprises two first power supply structures, wherein the two first power supply structures are respectively located at two sides of the second power supply structure along the second direction; and the display area is provided with a central line extending along the first direction, and an extension line of the central line overlaps with the second power supply structure; and
the third part comprises a first end portion and a second end portion in the second direction; and along the first direction, the first end portion is located at a side of the second sub-part in one of the two first power supply structure close to the display area, and the second end portion is located at a side of the second sub-part in the other one of the two first power supply structures close to the display area.

16. The display panel according to claim 2, wherein
the display area comprises a data line, a data connection line, a second power signal line, and a second auxiliary power line;
the data line and the second power signal line extend along the first direction, the second auxiliary power line extend along the second direction, and the second power signal line intersects with and is electrically connected to the second auxiliary power line; and the data line comprises a second data line, and the data connection line is electrically connected to the second data line;
the data connection line comprise at least one first line segment extending along the first direction and at least one second line segment extending along the second direction; and the at least one first line segment and the second power signal line are located in a same layer, and the at least one second line segment and the second auxiliary power line are located in a same layer;
the display area comprises a first area and a second area arranged along the second direction, a plurality of first line segments are continuously arranged along the second direction in the first area, and a plurality of second power signal lines are continuously arranged along the second direction in the second area; and
in the first direction, the first power supply structure at least partially overlaps with the first area, and the second power supply structure at least partially overlaps with the second area.

17. The display panel according to claim 2, wherein
the first power supply structure is a positive power supply structure, and the second power supply structure is a negative power supply structure.

18. The display panel according to claim 1, wherein
the first non-display area comprises a plurality of data leads, the data lead comprises a first lead segment and a second lead segment, and the first lead segment is located at a side of the second lead segment away from the display area along the first direction; the first lead segment extends along the first direction, and an extending direction of the second lead segment intersects with the first direction and intersects with the second direction; and the data lead comprises a plurality of second data leads;
the display area comprises a data line and a data connection line, the data line comprises a second data line and a third data line, one end of the data connection line is connected to the second data line, and another end of the data connection line is connected to the second data lead; and an extension line of the third data line overlaps with the first part, and the third data line is electrically connected to the second data lead;
at least part of the second data lead overlaps with the first power supply structure in the direction perpendicular to the plane of the substrate;
the display panel comprises a first metal layer and a second metal layer located at a side of the substrate, the second metal layer is located at a side of the first metal layer away from the substrate; and the second data lead comprise a third data sub-lead located in the first metal layer and a fourth data sub-lead located in the second metal layer; and
a plurality of third data sub-leads and a plurality of fourth data sub-leads are alternately arranged.

19. The display panel according to claim 1, wherein
the first non-display area comprises a first retaining wall; and
in the direction perpendicular to the plane of the substrate, the second sub-part at least partially overlaps with the first retaining wall.

20. The display panel according to claim 19, wherein
in the direction perpendicular to the plane of the substrate, the first retaining wall overlaps with an edge of the second sub-part on a side away from the display area in the first direction.

21. The display panel according to claim 1, wherein
at least part of the first part and at least part of the second part are electrically connected through a plurality of via holes, and/or
at least part of the first part and at least part of the second part are in planar contact connection.

22. The display panel according to claim 1, wherein
the first non-display area further comprises a bending area and a pad area; and the pad area is located at a side of the bending area away from the display area along the first direction;
the first non-display area comprises a first cross-over line, and the first cross-over line is connected to the first power supply structure and extends to the pad area through the bending area; and
the first power supply structure is connected to at least three first cross-over lines.

23. A display apparatus, comprising the display panel according to any one of claims 1 to 22.
